# DEMANDE DE BREVET EUROPEEN

(11) **EP 0 591 070 A1**
(43) Date de publication de la demande: **06.04.1994**
(21) Numéro de dépôt: 93420362.1
(22) Date de dépôt: 09.09.1993
(51) Int. Cl.: H05B 6/50, H03B 5/06

(54) **Dispositif anti-flash pour générateur haute fréquence capacitif**

(30) Priorité: 28.09.1992 FR 9211852
(71) Demandeur: THIMONNIER S.A., F-69650 St. Germain Au MT D'Or (FR)
(72) Inventeur:
(74) Mandataire: Bratel, Gérard

(57) **Abrégé**

Le générateur comprend un tube électronique (1) entretenant les oscillations d'un circuit oscillant (4,5), lui-même couplé à un circuit de sortie (18) comprenant un condensateur (21) constituant la charge. Le dispositif anti-flash comprend des moyens (22 à 33) qui bloquent le fonctionnement du tube électronique (1) par polarisation positive de la cathode (6) de ce tube.

Application : générateur pour traitement thermique de matériaux électriquement isolants.

## Description

L'invention concerne un dispositif anti-flash pour un générateur haute fréquence capacitif, aussi appelé générateur haute fréquence à pertes diélectriques. Un tel générateur comprend de façon généralement connue un tube électronique convenablement polarisé, entretenant les oscillations d'un circuit oscillant qui est lui-même couplé à un circuit de sortie, lequel comprend un condensateur constituant la charge, c'est-à-dire l'élément de puissance dont les pertes diélectriques sont mises à profit.

Dans l'industrie, les générateurs haute fréquence capacitifs servent à effectuer des traitements thermiques, tels que des échauffements en vue d'un soudage, sur des matériaux non conducteurs de l'électricité. Les pertes diélectriques de ces matériaux électriquement isolants, liées à l'utilisation de la haute fréquence, sont à l'origine de l'échauffement de ceux-ci.

Les matériaux électriquement isolants, qui ne sont pas parfaits, peuvent pendant de tels traitements thermiques être sujets à des arcs électriques internes, provenant par exemple de la non-homogénéité de leur matière, de bulles d'air ou de gaz existantes ou naissantes pendant le traitement qui vont s'ioniser, ou du champ électrique trop intense pendant le traitement. Les arcs électriques, ici dénommés "flashes", détériorent le matériau à traiter et il y a lieu de les détecter rapidement afin de limiter, voire d'inhiber les dégâts qu'ils provoquent. A cet effet, on munit utilement les générateurs en cause de circuits additionnels appelés dispositifs "anti-flash".

Tous les dispositifs anti-flash actuels sont basés sur le même principe de fonctionnement, qui consiste à bloquer les oscillations haute fréquence par l'application d'une tension de polarisation négative sur la grille du tube oscillateur, tel que triode, en cas de détection d'un flash dans le matériau à traiter. Cette tension de blocage de grille est appliquée au moyen d'un élément qui peut être un relais, un tube électronique, un composant semiconducteur, etc. La vitesse de réponse des dispositifs anti-flash actuels, fonctionnant selon ce principe, est relativement faible, le blocage de la tension haute fréquence s'effectuant en un temps de l'ordre de 100 microsecondes à 20 millisecondes. Cet état de la technique est illustré par les documents US-A-2 868 941 et US-A-3 129 313.

La présente invention se propose d'améliorer notablement les performances des dispositifs anti-flash des générateurs haute fréquence du genre concerné, du point de vue de leur vitesse de réponse, de manière à leur permettre de jouer pleinement leur rôle.

A cet effet, l'invention a essentiellement pour objet un dispositif anti-flash pour générateur haute fréquence capacitif avec un tube électronique entretenant les oscillations d'un circuit oscillant, lui-même couplé à un circuit de sortie comprenant un condensateur constituant la charge, le tube électronique comportant une anode reliée à une source de tension continue et au circuit oscillant, une cathode et au moins une grille, le dispositif anti-flash étant caractérisé en ce qu'il comprend des moyens prévus pour bloquer le fonctionnement du tube électronique par une polarisation positive de la cathode de ce tube.

Ainsi, contrairement à toutes les réalisations actuelles, la présente invention propose d'assurer, en cas de détection d'un "flash", le blocage de l'oscillateur par la cathode du tube électronique ; ce principe nouveau de blocage de la tension haute fréquence procure une mise à l'arrêt très rapide du générateur, en un temps qui peut être de l'ordre de 5 microsecondes, la vitesse exacte de réponse dépendant des composants du circuit.

Selon un mode de réalisation préféré de l'invention, le dispositif anti-flash comprend un comparateur dont une première entrée est en relation avec une source de tension injectée dans le condensateur constituant la charge, dont l'autre entrée est reliée à une source de tension de référence, et dont la sortie est raccordée, par un étage intermédiaire, à un élément à fonction d'interrupteur branché entre la cathode du tube électronique et un point de basse tension continue, telle que la masse. Le comparateur surveille ainsi l'état de la charge, et lorsqu'un flash veut prendre naissance, il détecte une différence de tension et émet à sa sortie un signal qui modifie l'état de l'étage intermédiaire. Ce dernier provoque lui-même le passage de l'élément à fonction d'interrupteur d'un état normalement conducteur à un état bloqué, pour lequel la cathode du tube électronique n'est plus reliée à la masse et peut être amenée à la tension positive de blocage désirée.

Selon une caractéristique complémentaire, un point situé entre la cathode du tube électronique et l'élément à fonction d'interrupteur est relié à une source de tension continue, réalisant la polarisation positive de blocage lorsque l'élément à fonction d'interrupteur est à l'état bloqué. Cette source de tension continue est réalisable commodément sous la forme d'un diviseur de tension résistif, branché entre les polarités positive et négative de la haute tension continue d'alimentation.

De toute façon, l'invention sera mieux comprise à l'aide de la description qui suit, en référence au dessin schématique annexé représentant, à titre d'exemple non limitatif, un mode de réalisation de ce dispositif anti-flash pour générateur haute fréquence capacitif :
Figure 1 est un schéma électrique d'un générateur haute fréquence capacitif avec dispositif anti-flash conforme à la présente invention ;
Figure 2 est un diagramme illustrant le fonctionnement de ce générateur, dans les conditions normales et en cas de flash avec intervention du dispositif selon l'invention.

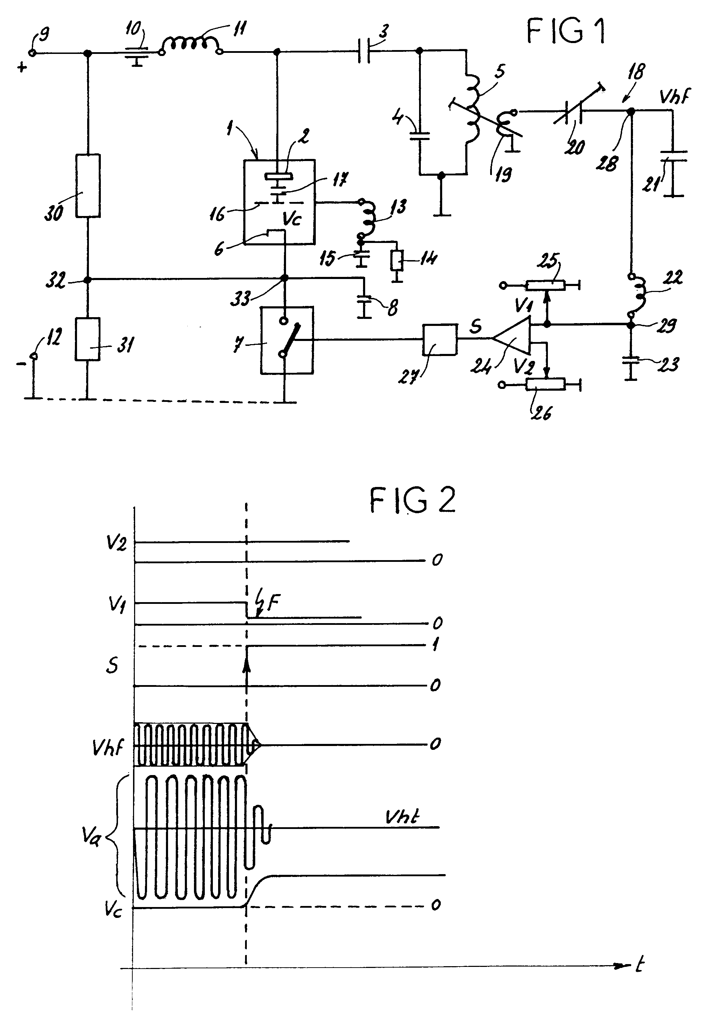

La figure 1 montre un générateur haute fréquence capacitif de puissance, comportant un tube électronique 1 qui, dans l'exemple considéré, est un tube triode. Le tube électronique 1 a son anode 2 reliée, par l'intermédiaire d'un condensateur 3, à un circuit oscillant "parallèle" formé par un condensateur 4 et par une self 5, circuit dont la fréquence d'oscillation est déterminée par les valeurs de ses composants 4 et 5.

La cathode 6 du tube électronique 1 est reliée à la masse du circuit par l'intermédiaire d'un élément 7 qui a un rôle d'interrupteur. Un condensateur 8, monté en parallèle avec l'élément 7, sert au découplage de cet élément.

L'alimentation de l'ensemble en haute tension continue a sa polarité positive 9 reliée à l'anode 2 du tube électronique 1 à travers un condensateur de découplage 10 et une self de filtrage 11. La polarité négative 12 de la source d'alimentation est connectée à la masse du circuit.

Le tube électronique 1 fonctionne en mode auto-oscillateur classe "C". Ce type de fonctionnement est assuré par une self 13, une résistance 14 et un condensateur 15, ces éléments étant reliés à la grille 16 du tube 1, et par la capacité inter-électrode anode-grille 17 de ce tube 1. La capacité interne 17 du tube 1 et la self 13 forment un diviseur de tension haute fréquence, et réalisent un déphasage de 180°. La tension réduite et déphasée de 180°, se trouvant aux bornes de la self 13, est appliquée à la grille 16 du tube 1, ceci étant nécessaire pour obtenir des oscillations. Grâce à la résistance 14 traversée par le courant de grille du tube 1, la polarisation négative du mode de fonctionnement en classe "C" est assurée.

Le condensateur 10 et la self 11 empêchent que la tension haute fréquence ne revienne vers l'alimentation. Le condensateur 3 empêche le court-circuitage de l'alimentation haute tension à travers la self 5.

Le circuit de sortie haute fréquence 18 est composé d'une self 19, d'un condensateur variable 20 et d'un autre condensateur 21, ce dernier constituant la charge. La self 19 du circuit de sortie 18 est couplée avec la self 5 du circuit oscillant, et l'énergie haute fréquence transmise est maximale lorsque ce circuit de sortie 18 est amené, par le condensateur variable 20, à une fréquence de résonnance égale à la fréquence de résonnance du circuit oscillant formé par le condensateur 4 et la self 5.

Le dispositif anti-flash comprend une self 22, un condensateur 23, un comparateur 24, deux potentiomètres 25,26 et un étage intermédiaire 27.

La self 22 et le condensateur 23 sont branchés, en série, entre un point 28 du circuit de sortie 18, situé entre les deux condensateurs 20 et 21, d'une part, et la masse d'autre part.

Une première entrée du comparateur 24 est reliée au potentiomètre 25 constituant une source de tension ajustable, ainsi qu'à un point 29 situé entre la self 22 et le condensateur 23. L'autre entrée du comparateur 24 est reliée au second potentiomètre 26 constituant une autre source de tension ajustable.

La sortie du comparateur 24 est connectée à l'entrée de l'étage intermédiaire 27, réalisé comme une source de tension ou de courant, éventuellement comme un amplificateur de signal. La sortie de l'étage intermédiaire 27 commande l'élément 7 qui peut être constitué par un interrupteur, un contact de relais, un composant semi-conducteur tel qu'un transistor classique ou Mosfet, ou tout autre composant à fonction d'interrupteur.

Enfin, un diviseur de tension résistif, formé par deux résistances en série 30 et 31, est branché entre la polarité positive 9 de la haute tension continue d'alimentation et la masse. Le point intermédiaire 32, entre les résistances 30 et 31, est relié à un point 33 situé entre la cathode 6 du tube électronique 1 et l'élément 7 à fonction d'interrupteur.

En fonctionnement normal, l'élément 7 est conducteur et la cathode 6 du tube électronique 1 est ainsi reliée à la masse, du point de vue "courant continu". Le tube 1 peut alors fonctionner d'une manière classique et normale, en relation avec les autres éléments du circuit.

Le comparateur 24 surveille une tension continue V1, réglée par le potentiomètre 25 et injectée dans le condensateur 21 constituant la charge, en comparant cette tension V1 avec une tension de référence V2 délivrée et prédéterminée par le potentiomètre 26. Dans les conditions normales, les tensions V1 et V2 sont sensiblement égales ; l'état de sortie S du comparateur 24 maintient alors l'étage intermédiaire 27 dans un état désactivé qui, lui-même, maintient l'élément 7 à l'état conducteur. Ce fonctionnement dans les conditions normales est illustré dans la partie gauche du diagramme de la figure 2, représentant de haut en bas : la tension de référence V2, la tension V1, l'état S (niveau logique 0 ou 1) de la sortie du comparateur 24, la tension haute fréquence Vhf au condensateur 21 consituent la charge, la tension haute fréquence Va sur l'anode 2 du tube 1, se superposant à une haute tension continue Vht, et la tension continue Vc sur la cathode 6 du tube 1.

Si un flash F veut prendre naissance aux bornes du condensateur 21, à travers le matériau à traiter thermiquement, la tension V1 réglée par le potentiomètre 25 va devenir plus faible que celle V2 réglée par le potentiomètre 26. Dès lors, le comparateur 24 détecte cette différence de tensions, son état de sortie S est modifié, et active l'étage intermédiaire 27. Le changement d'état de l'étage intermédiaire 27 provoque lui-même un changement d'état de l'élément 7, qui passe de l'état conducteur à l'état bloqué. Par suite du blocage de l'élément 7, la cathode 6 du tube électronique 1 ne sera plus reliée à la masse, donc au potentiel "zéro volt".

La cathode 6 du tube électronique 1 reçoit alors une tension continue de polarisation positive, déterminée par le diviseur de tension résistif 30,31,32. La tension de la grille 16 du tube 1 devient ainsi plus négative qu'auparavant, ce qui provoque le blocage du tube 1 ainsi que des oscillations qu'il entretenait, comme cela apparaît sur la ligne Va du diagramme de la figure 2.

La tension de polarisation positive de blocage, appliquée à la cathode 6 du tube électronique 1, est déterminée et ajustable par le choix des résistances 30 et 31. Elle possède avantageusement une valeur égale à environ 10 % de la haute tension continue d'alimentation. La self 22 et le condensateur 23 servent à empêcher que la tension haute fréquence Vhf du condensateur 21 constituant la charge ne revienne dans le comparateur 24.

Le dispositif anti-flash, décrit ci-dessus, est applicable aux générateurs auto-oscillateurs classiques, ainsi qu'aux générateurs pilotés, qu'ils soient amplificateurs ou émetteurs.

Il va de soi que l'invention ne se limite pas au seul mode de réalisation de ce dispositif anti-flash pour générateur haute fréquence capacitif qui a été décrit ci-dessus, à titre d'exemple ; elle en embrasse, au contraire, toutes les variantes respectant le même principe, à savoir le blocage de l'oscillateur par la cathode du tube électronique. Ainsi, le principe de l'invention reste valable lorsque le générateur comporte un tube tétrode (avec une grille supplémentaire) au lieu d'un tube triode. Une autre variante du dispositif consiste à remplacer le diviseur de tension résistif 30,31,32 par une source d'alimentation continue auxiliaire. Dans le même ordre d'idées, le circuit de sortie alimentant la charge peut être à couplage direct ou indirect, inductif ou capacitif, sans que l'on s'éloigne du cadre de l'invention.

## Revendications

1. Dispositif anti-flash pour générateur haute fréquence capacitif, avec un tube électronique (1) entretenant les oscillations d'un circuit oscillant (4,5), lui-même couplé à un circuit de sortie (18) comprenant un condensateur (21) constituant la charge, le tube électronique (1) comportant une anode (2) reliée à une source de tension continue (9) et au circuit oscillant (4,5), une cathode (6) et au moins une grille (16), caractérisé en ce que le dispositif anti-flash comprend des moyens (22 à 33) prévus pour bloquer le fonctionnement du tube électronique (1) par polarisation positive de la cathode (6) de ce tube (1).

2. Dispositif anti-flash pour générateur haute fréquence capacitif selon la revendication 1, caractérisé en ce que ce dispositif anti-flash comprend un comparateur (24) dont une première entrée est en relation avec une source de tension (25,V1) injectée dans le condensateur (21) constituant la charge, dont l'autre entrée est reliée à une source de tension de référence (26,V2), et dont la sortie est raccordée, par un étage intermédiaire (27), à un élément (7) à fonction d'interrupteur branché entre la cathode (6) du tube électronique (1) et un point de basse tension continue, tel que la masse (12) , tandis qu'un point (33) situé entre la cathode (6) du tube électronique (1) et l'élément (7) à fonction d'interrupteur est relié à une source de tension continue (30,31,32), réalisant la polarisation positive de blocage lorsque l'élément (7) à fonction d'interrupteur est bloqué.

3. Dispositif anti-flash pour générateur haute fréquence capacitif selon la revendication 2, caractérisé en ce que la source de tension (V1) injectée dans le condensateur (21) constituant la charge, de même que la source de tension de référence (V2) pour le comparateur (24), sont constituées par des sources de tension ajustables, telles que des potentiomètres (25,26).

4. Dispositif anti-flash pour générateur haute fréquence capacitif selon la revendication 3, caractérisé en ce que la première entrée du comparateur (24), reliée à l'un des potentiomètres (25), est reliée aussi à un point (29) situé entre une self (22) et un condensateur (23) branchés, en série, entre un point (28) du circuit de sortie (18) et la masse.

5. Dispositif anti-flash pour générateur haute fréquence capacitif selon l'une quelconque des revendications 2 à 4, caractérisé en ce que la source de tension continue de blocage, reliée au point (33) situé entre la cathode (6) du tube électronique (1) et l'élément (7) à fonction d'interrupteur, est réalisée sous la forme d'un diviseur de tension résistif (30,31,32), branché entre les polarités positive (9) et négative (12) de la haute tension continue d'alimentation du générateur.

6. Dispositif anti-flash pour générateur haute fréquence capacitif selon la revendication 5, caractérisé en ce que la tension de polarisation positive de blocage est déterminée, par les résistances (30,31) du diviseur de tension précité, de manière à posséder une valeur égale à environ 10 % de la haute tension continue d'alimentation.

7. Dispositif anti-flash pour générateur haute fréquence capacitif selon l'une quelconque des revendications 1 à 6, caractérisé par son application à un générateur haute fréquence capacitif utilisé pour effectuer des traitements thermiques sur des matériaux électriquement isolants, par mise à profit des pertes diélectriques du condensateur (21) constituant la charge.
